(19) Europäisches Patentamt / European Patent Office / Office européen des brevets

(11) **EP 4 234 757 B1**

(12) **EUROPEAN PATENT SPECIFICATION**

(45) Date of publication and mention
of the grant of the patent:
**13.08.2025 Bulletin 2025/33**

(21) Application number: **21885047.7**

(22) Date of filing: **22.10.2021**

(51) International Patent Classification (IPC):
*C23C 14/50* (2006.01)   *C23C 14/54* (2006.01)
*H01L 21/687* (2006.01)   *H01L 21/67* (2006.01)
*H01J 37/32* (2006.01)

(52) Cooperative Patent Classification (CPC):
**H01L 21/67103; C23C 14/50; C23C 14/541;
H01J 37/32724; H01L 21/67109; H01L 21/68785**

(86) International application number:
**PCT/CN2021/125692**

(87) International publication number:
**WO 2022/089320 (05.05.2022 Gazette 2022/18)**

(54) **WAFER CARRYING MECHANISM AND SEMICONDUCTOR PROCESS APPARATUS**

WAFERTRÄGERMECHANISMUS UND HALBLEITERVERARBEITUNGSVORRICHTUNG

MÉCANISME DE SUPPORT DE TRANCHE ET APPAREIL DE TRAITEMENT DE
SEMI-CONDUCTEURS

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**

(30) Priority: **26.10.2020 CN 202022404539 U**

(43) Date of publication of application:
**30.08.2023 Bulletin 2023/35**

(73) Proprietor: **Beijing NAURA Microelectronics
Equipment Co., Ltd.
Beijing 100176 (CN)**

(72) Inventor: **YU, Bin
Beijing 100176 (CN)**

(74) Representative: **Cohausz & Florack
Patent- & Rechtsanwälte
Partnerschaftsgesellschaft mbB
Bleichstraße 14
40211 Düsseldorf (DE)**

(56) References cited:
WO-A1-2020/073779      CN-A- 1 907 897
CN-A- 103 794 538      CN-A- 104 862 660
CN-A- 111 477 569      CN-A- 111 477 569
CN-U- 206 907 749      CN-U- 213 951 334
TW-A- 201 516 173      US-A1- 2013 286 533
US-A1- 2016 111 315      US-A1- 2022 051 923
US-A1- 2023 143 413

## Description

## Field

The present application relates to the field of semiconductor process apparatuses, and in particular, to a wafer carrying mechanism and a semiconductor process apparatus.

## Background

During the high temperature physical vapor deposition process, a carrying plate needs to be used to heat a wafer to a certain process temperature, and the carrying plate needs to have the capability to regulate the wafer temperature in a high temperature state, that is, the carrying plate not only can heat the wafer, but also can cool the wafer when needed. The cooling capacity requirements on the carrying plate differ for different processes (especially the high-temperature process), for example, there are processes that only require the carrying plate to heat the wafer, and there are processes that require the carrying plate to have a strong cooling capacity. In general, it is difficult to meet the needs of different processes using the same carrying plate.

Chinese patent application CN111477569A discloses a heating plate, which is capable of moving up and down relative to a heating plate by adjusting a lifting structure; and International Patent application WO2020/073779A1 discloses a thin wall structure, which is respectively connected to a heating body and a cooling pipeline for reducing efficiency of heat dissipation between the heating body and the cooling pipeline.

## Summary

A first objective of the present application is to provide a wafer carrying mechanism to solve the technical problem that existing wafer carrying mechanisms have difficulty in meeting the needs of various high-temperature processes.

A wafer carrying mechanism provided by the present application is used for a semiconductor process apparatus, the wafer carrying mechanism is disposed in a process chamber of the semiconductor process apparatus, the wafer carrying mechanism includes a mounting support, a carrying plate, a heater, a cooling structure, and a distance adjusting assembly, wherein the carrying plate is disposed on the heater for carrying a wafer; the heater is disposed on the mounting support, and an accommodating space is formed between the heater and the mounting support; the cooling structure is located in the accommodating space for cooling the heater; and the distance adjusting assembly is separately connected to the mounting support and the cooling structure for adjusting a vertical distance between the cooling structure and the heater;

the mounting support includes a flange plate, and a support plate, wherein the flange plate is connected to the heater, and the accommodating space is formed between the flange plate and the heater; the support plate is connected to the flange plate, and at least a portion of the support plate is located in the accommodating space and connected to the cooling structure for supporting the cooling structure; and

the distance adjusting assembly includes a first distance adjusting piece and/or a second distance adjusting piece, the cooling structure is connected to the support plate by the first distance adjusting piece, and the first distance adjusting piece is used for adjusting a vertical distance between the cooling structure and the support plate; and/or the support plate is connected to the flange plate by the second distance adjusting piece, and the second distance adjusting piece is used for adjusting a vertical distance between the support plate and the heater.

Further, the first distance adjusting piece includes threaded rods, nuts, and washers, wherein there are a plurality of threaded rods, and the threaded rods are arranged at intervals along the circumference of the support plate; each threaded rod is vertically disposed, and an upper end of the threaded rod is fixedly connected to the cooling structure; first unthreaded holes are provided at positions corresponding to the threaded rods on the support plate, and the threaded rods penetrate through the first unthreaded holes;

the washers are located between the cooling structure and the support plate for adjusting the vertical distance between the cooling structure and the support plate by setting the number and/or thickness of the washers; and
the number of the nuts is the same as the number of the threaded rods, and the nuts are located below the support plate; the nuts are threadedly matched with the threaded rods in one-to-one correspondence for fixedly connecting the cooling structure, the support plate, and the washers.

Further, the flange plate is provided with a central through hole, and a first connecting portion is provided on a hole wall of the central through hole; a portion of the support plate is located in the central through hole; a second connecting portion is provided on an outer peripheral wall of the support plate; the second connecting portion and the first connecting portion are disposed in a superimposing mode, and the second connecting portion is located under the first connecting portion;

a plurality of threaded holes are provided on the first connecting portion at intervals along the circumference of the support plate, and a plurality of second unthreaded holes are provided on the second connecting portion; the number of the second unthreaded holes is the same as the number of the threaded holes, and the second unthreaded holes and the threaded holes are provided in one-to-one correspondence; and

the second distance adjusting piece includes a plurality of screws, the number of the screws is the same as the number of the threaded holes, and the screws pass through the second unthreaded holes in one-to-one correspondence and are threadedly connected to the corresponding threaded holes; the vertical distance between the support plate and the heater is adjusted by adjusting relative positions of the screws and the threaded holes in an axial direction of the threaded holes.

Further, a connecting wall extending in the direction of the heater is provided on the flange plate and at an edge of the flange plate, the connecting wall is fixedly connected to the heater, and the accommodating space is formed between an inner peripheral surface of the connecting wall, a lower surface of the heater and an upper surface of the flange plate.

Further, the wafer carrying mechanism further includes a pressing ring, and the pressing ring includes an annular body fixedly connected to the heater and surrounding the carrying plate, and pressing teeth disposed in the annular body and protruding relative to an inner peripheral surface of the annular body, wherein there are a plurality of pressing teeth, and the pressing teeth are arranged at intervals along the circumference of the annular body, at least a portion of each of the pressing teeth being elastically superimposed on the carrying plate for pressing the carrying plate against the heater.

Further, the vertical distance between the cooling structure and the heater is greater than or equal to 0.5 mm and less than or equal to 4 mm.

Further, the cooling structure includes a cooling screen, and a cooling plate connected to a bottom of the cooling screen, wherein the cooling plate is provided with a flow channel, the flow channel is used for delivering a cooling liquid, and a radial dimension of the cooling screen is greater than or equal to a radial dimension of the carrying plate.

Further, the heater includes a heater body, and a heating wire embedded in the heater body.

The benefits of the wafer carrying mechanism provided by the present application are as follows:
according to the wafer carrying mechanism, the vertical distance between the cooling structure and the heater is adjusted by means of the distance adjusting assembly separately connected to the mounting support and the cooling structure. Not only can the heat conduction efficiency of gas be adjusted to enable adjustment of the cooling capacity, thereby meeting the needs of different high-temperature processes, but also the cooling structure and the heater are made in a non-direct contact state, in this way, during use of the wafer carrying mechanism, the risk of shattering of the carrying plate by the heater due to sudden cooling of the cooling structure can be avoided, thus ensuring that the carrying plate can always be cooled at high temperature, and making the wafer carrying mechanism more advantageous in high-temperature processes.

A second objective of the present application is to provide a semiconductor process apparatus to solve the technical problem that existing semiconductor process apparatuses have difficulty in meeting the needs of different high-temperature processes.

The semiconductor process apparatus provided by the present application includes a process chamber and the aforementioned wafer carrying mechanism, the wafer carrying mechanism being disposed within the process chamber.

The benefits brought about by the semiconductor process apparatus provided by the present application are as follows:
by providing the aforementioned wafer carrying mechanism provided by the present application within the process chamber of the semiconductor process apparatus, the semiconductor process apparatus accordingly has all the advantages of the aforementioned wafer carrying mechanism, which are not described in any further detail herein.

**Brief Description of the Drawings**

To describe the technical solutions in the embodiments of the present application or in the prior art more clearly, the following briefly introduces the drawings required for describing the embodiments or the prior art. Apparently, the drawings in the following description are merely embodiments of the present application, and those of ordinary skill in the art may still derive other drawings from these drawings without creative efforts.

FIG. 1 is a cross-sectional view of a structure of a wafer carrying mechanism according to an embodiment of the present application when a wafer is carried;
FIG. 2 is a top view of a structure of the connection between a pressing ring and a carrying plate of the wafer carrying mechanism according to an embodiment of the present application;
FIG. 3 is an enlarged view of a partial structure of the connection between the pressing ring and the carrying plate of the wafer carrying mechanism according to an embodiment of the present application;
FIG. 4 is a cross-sectional view of a partial structure of the wafer carrying mechanism according to an embodiment of the present disclosure;
FIG. 5 is a top view of a structure of a support plate of the wafer carrying mechanism according to an embodiment of the present disclosure;
FIG. 6 is an enlarged view of a partial structure of the structure shown in FIG. 1; and

FIG. 7 is a partial structural view of the wafer carrying mechanism according to an embodiment of the present disclosure.

Description of reference signs:

100-mounting support; 200-carrying plate; 300-heater; 400-cooling structure; 500-first distance adjusting piece; 600-second distance adjusting piece; 700-pressing ring; 800-fastening screw; 900-wafer;
110-flange plate; 110a-central through hole; 111-first connecting portion; 112-connecting wall; 120-support plate; 121-first unthreaded hole; 122-second unthreaded hole; 123-routing hole; 124-second connecting portion;
310-heater body; 320-heating wire;
410-cooling screen; 411-process hole; 420-cooling plate; 430-cooling liquid tube;
510-threaded rod; 520-nut; 530-washer;
710-annular body; 720-pressing tooth.

**Detailed Description of the Embodiments**

In order that the above objectives, features, and advantages of the present application will become more apparent, the following detailed description of specific embodiments of the present disclosure will be made in conjunction with the accompanying drawings. It should be understood that the specific embodiments described herein are intended only to explain the present application and are not intended to limit it.

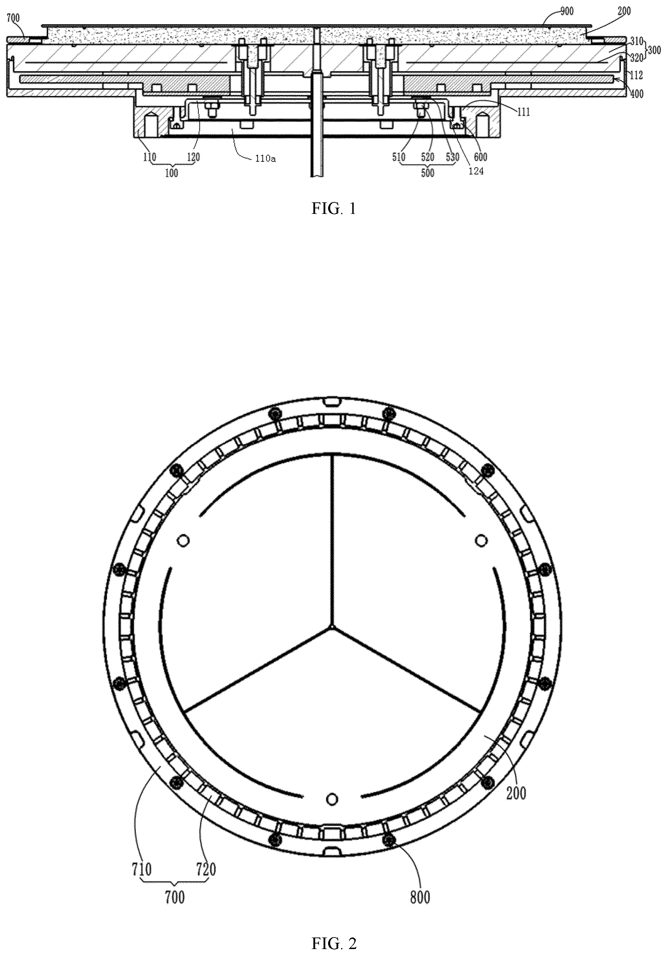

FIG. 1 is a cross-sectional view of a structure of a wafer carrying mechanism according to an embodiment when a wafer is carried. As shown in FIG. 1, the present embodiment provides a wafer carrying mechanism used for a semiconductor process apparatus, specifically, the wafer carrying mechanism is disposed in a process chamber of the semiconductor process apparatus, the wafer carrying mechanism includes a mounting support 100, a carrying plate 200, a heater 300, a cooling structure 400, and a distance adjusting assembly, wherein the carrying plate 200 is disposed on the heater 300 for carrying a wafer 900, optionally, a lower surface of the carrying plate 200 is attached to an upper surface of the heater 300 to improve heat conduction efficiency of the heater 300. The mounting support 100 is fixedly disposed in the process chamber, the heater 300 is disposed on the mounting support 100, and an accommodating space is formed between the heater 300 and the mounting support 100; the cooling structure 400 is located within the accommodating space for cooling the heater 300.

During use of the wafer carrying mechanism, the heat generated by heating of the heater 300 can be transferred directly to the carrying plate 200 to provide the desired temperature of the wafer 900 under a current high-temperature process; the cooling structure 400 acts as a heat sink for the carrying plate 200, however, the heater 300 is what the cooling structure 400 directly affects, that is, the carrying plate 200 is indirectly cooled by cooling the heater 300. By changing the heating power of the heater 300, a balance between the heating power of the heater 300 and the cooling power of the cooling structure 400 may be achieved, thereby enabling the wafer 900 disposed on the carrying plate 200 to be always maintained at a desired process temperature.

When it is required to cool the carrying plate 200, only the heating power of the heater 300 needs to be reduced, the heater 300 is cooled by the cooling structure 400 such that the temperature of the heater 300 is reduced until the temperature of the heater 300 is lower than the temperature of the carrying plate 200, at which point heat will be transferred from the carrying plate 200 to the heater 300, and the heat of the heater 300 is further transferred to the cooling structure 400, achieving indirect cooling of the carrying plate 200 by the cooling structure 400.

The distance adjusting assembly is separately connected to the mounting support 100 and the cooling structure 400 for adjusting a vertical distance between the cooling structure 400 and the heater 300. By adjusting the vertical distance between the cooling structure 400 and the heater 300 by means of the aforementioned distance adjusting assembly, the heat conduction efficiency of gas can be adjusted to enable adjustment of the cooling capacity, thereby meeting the needs of different high-temperature processes.

Furthermore, by adjusting the vertical distance between the cooling structure 400 and the heater 300 by means of the aforementioned distance adjusting assembly, the cooling structure 400 and the heater 300 may also be in a non-direct contact state, in this way, during use of the wafer carrying mechanism, the risk of shattering of the carrying plate 200 by the heater 300 due to sudden cooling of the cooling structure 400 can be avoided, thus ensuring that the carrying plate 200 can always be cooled at high temperature, and making the wafer carrying mechanism more advantageous in high-temperature processes.

From the formula for heat conduction

$$Q = \lambda A \frac{T1 - T2}{\Delta x}$$

, where Q is the heat flow rate of heat conduction, $\lambda$ is the heat conductivity of air, A is the heat conduction area, T1 is the temperature of the heater 300, T2 is the temperature of the cooling structure 400, and $\Delta x$ is the vertical distance between the heater 300 and the cooling structure 400, it can be seen that the smaller the vertical distance, the larger the heat flow rate Q of heat conduction; conversely, the larger the vertical distance, the smaller the heat flow rate Q of heat conduction, based on this, adjustment of the heat flow rate Q of heat conduction can be achieved by adjusting the aforementioned vertical distance, thereby achieving different heat conduction effects.

In some optional embodiments, the carrying plate 200 is an electrostatic chuck. The electrostatic chuck has relatively high wafer utilization, few particles, and uniform edge etching and deposition rates. Using the electrostatic chuck to carry the wafer 900 can avoid movement or misalignment of the wafer 900 during processing, and the electrostatic chuck can be electrically connected to a radio frequency power supply to provide radio frequency bias to the wafer 900, and the surface temperature of the wafer 900 can also be controlled by using the aforementioned heater 300 and cooling structure 400. Specifically, the carrying plate 200 may be fabricated from a dielectric material such as $Al_2O_3$ ceramic, AlN ceramic, and the like, which contains therein a DC electrode electrically connected to a DC power supply, and an electrostatic adsorption force is generated to adsorb the wafer 900 by applying a DC voltage to the DC electrode.

With continued reference to FIG. 1, in some optional embodiments, the heater 300 may include a heater body 310, and a heating wire 320 embedded in the heater body 310, wherein the heating wire 320 is in electrical connection with a power supply. During operation of the wafer carrying mechanism, the power supply energizes the heating wire 320, the heating wire 320 generates and transfers heat to the heater body 310, causing the temperature of the heater body 310 to rise, and the heater body 310 with rising temperature transfers heat to the carrying plate 200, thereby achieving heating of the carrying plate 200.

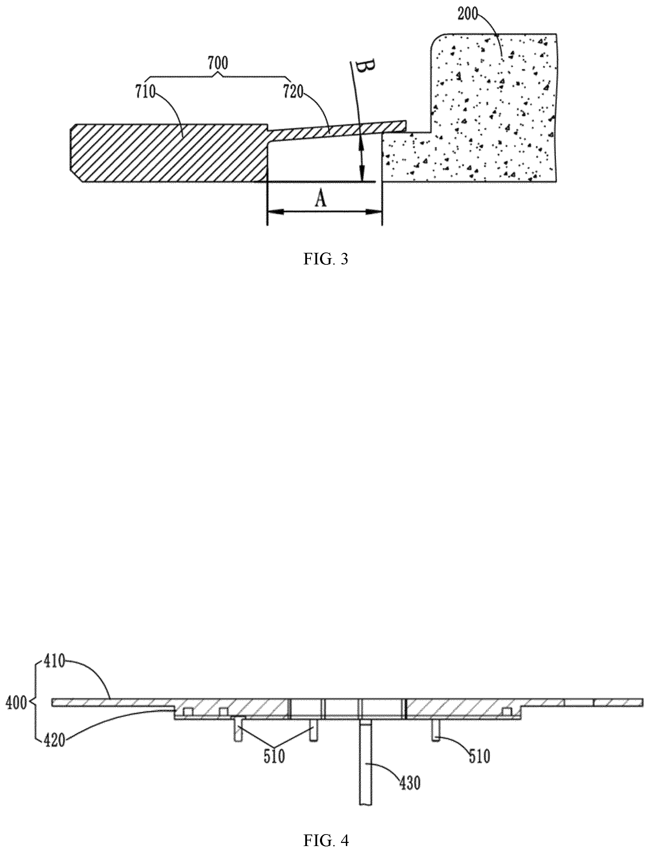

FIG. 2 is a top view of a structure of the connection between a pressing ring 700 and a carrying plate 200 of the wafer carrying mechanism according to an embodiment. FIG. 3 is an enlarged view of a partial structure of the connection between the pressing ring 700 and the carrying plate 200 of the wafer carrying mechanism according to an embodiment. With continued reference to FIG. 1, in conjunction with FIGS. 2 and 3, in some optional embodiments, the wafer carrying mechanism further includes a pressing ring 700, and the carrying plate 200 is disposed on the heater 300 by the pressing ring 700. Specifically, the pressing ring 700 includes an annular body 710 fixedly connected to the heater 300 and surrounding the carrying plate 200, and pressing teeth 720 disposed in the annular body 710 and protruding relative to an inner peripheral surface of the annular body 710, wherein there are a plurality of pressing teeth 720, and the pressing teeth 720 are arranged at intervals along the circumference of the annular body 710, at least a portion of each of the pressing teeth 720 being elastically superimposed on the carrying plate 200 for pressing the carrying plate 200 against the heater 300.

Providing of the pressing ring 700 enables the fixing of the carrying plate 200 on the heater 300. Moreover, during operation of the wafer carrying mechanism, a difference in the amount of expansion exists between the carrying plate 200 and the heater 300 due to different coefficients of thermal expansion. As the heater body 310 has a greater coefficient of thermal expansion and a greater amount of expansion relative to the carrying plate 200, the radial distance A between the pressing ring 700 and the carrying plate 200 may increase, to this end, by elastically superimposing at least a portion of each pressing tooth 720 on the carrying plate 200, elastic deformation of the pressing tooth 720 can be utilized to adapt to the increased radial distance A. For example, as shown in FIG. 3, due to existence of an inclination angle B of the pressing tooth 720 with respect to a horizontal plane, the inclination angle B causes the pressing tooth 720 to always apply elastic pressure to the carrying plate 200, in this case, the pressing tooth 720 is able to always press the carrying plate 200 even if the radial distance A increases, thus avoiding misalignment of the carrying plate 200.

In some optional embodiments, the thickness of the pressing teeth 720 is 0.5 mm. By such arrangement, on the one hand, it is able to guarantee that the pressing teeth 720 apply a sufficient pressing force to the carrying plate 200 and guarantee the reliability of fixing of the carrying plate 200, and on the other hand, it is also able to avoid damage to the carrying plate 200 due to excessive pressing force.

With continued reference to FIG. 2, in some optional embodiments, the annular body 710 of the pressing ring 700 is fixedly connected to the heater body 310 of the heater 300 by a plurality of fastening screws 800. When it is required to maintain the pressing ring 700, by such arrangement, the pressing ring 700 can be directly removed from the heater 300, and the pressing ring 700 can be installed back after the maintenance is completed, which is convenient and efficient.

With continued reference to FIG. 1, in some optional embodiments, the mounting support 100 includes a flange plate 110, and a support plate 120, wherein the flange plate 110 is connected to the heater 300, and the aforementioned accommodating space is formed between the flange plate 110 and the heater 300; the support plate 120 is connected to the flange plate 110, and at least a portion of the support plate 120 is located in the aforementioned accommodating space and connected to the cooling structure 400 for supporting the cooling structure 400. The distance adjusting assembly includes a first distance adjusting piece 500 and/or a second distance adjusting piece 600, the cooling structure 400 is connected to the support plate 120 by the first distance adjusting piece 500, and the first distance adjusting piece 500 is used for adjusting a vertical distance between the cooling structure 400 and the support plate 120; and/or, the support plate 120 is connected to the flange plate 110 by the second distance adjusting piece 600, and the second distance adjusting piece 600 is used for adjusting a vertical distance between the support plate 120 and the heater 300.

In the wafer carrying mechanism, when the distance adjusting assembly includes only the first distance adjusting piece 500, the first distance adjusting piece 500 can be utilized to adjust the vertical distance between the cooling structure 400 and the support plate 120 for the purpose of adjusting the vertical distance between the cooling structure 400 and the heater 300; when the distance adjusting assembly includes only the second distance adjusting piece 600, the second distance adjusting piece 600 can be utilized to adjust the vertical distance between the support plate 120 and the heater 300. As a change in the position of the support plate 120 causes a consequent change in the position of the cooling structure 400 connected to the support plate 120, the purpose of adjusting the vertical distance between the cooling structure 400 and the heater 300 is indirectly achieved; when the distance adjusting assembly includes both the first distance adjusting piece 500 and the second distance adjusting piece 600, either the first distance adjusting piece 500 or the second distance adjusting piece 600 or both of the first distance adjusting piece 500 and the second distance adjusting piece 600 can be utilized for the purpose of adjusting the vertical distance between the cooling structure 400 and the heater 300.

The wafer carrying mechanism may enable adjustment of the vertical distance between the cooling structure 400 and the heater 300 by selectively using the first distance adjusting piece 500 and/or the second distance adjusting piece 600, moreover, connection to components in the process chamber can also be achieved by means of the flange plate 110, thereby achieving fixing of the wafer carrying mechanism of the present embodiment in the process chamber.

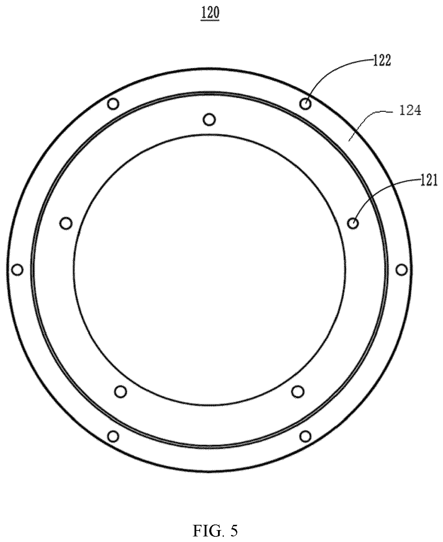

FIG. 4 is a cross-sectional view of a partial structure of the wafer carrying mechanism according to an embodiment. FIG. 5 is a top view of a structure of a support plate 120 of the wafer carrying mechanism according to an embodiment. With continued reference to FIG. 1, in conjunction with FIGS. 4 and 5, in some optional embodiments, the first distance adjusting piece 500 includes threaded rods 510, nuts 520, and washers 530, wherein there are a plurality of threaded rods 510, and the threaded rods 510 are arranged at intervals along the circumference of the support plate 120; each threaded rod 510 is vertically disposed, and an upper end of the threaded rod 510 is fixedly connected to the cooling structure 400; first unthreaded holes 121 are provided at positions corresponding to the threaded rods 510 on the support plate 120, and the threaded rods 510 penetrate through the first unthreaded holes 121; the washer 530 is provided on each threaded rod 510 in a sleeving mode and the washer 530 is located between the cooling structure 400 and the support plate 120 for adjusting the vertical distance between the cooling structure 400 and the support plate 120 by setting the number and/or thickness of the washer 530. When the vertical distance between the cooling structure 400 and the heater 300 needs to be adjusted using the first distance adjusting piece 500, the washers 530 of a suitable number and/or thickness may be stacked between the cooling structure 400 and the support plate 120 depending on the desired distance to bring the vertical distance to the desired distance. Optionally, to ensure levelness of the cooling structure 400, the number and/or thickness of the washers 530 disposed on each threaded rod 510 in the sleeving mode is identical.

The number of the nuts 520 is the same as the number of the threaded rods 510, and the nuts 520 are located below the support plate 120; the nuts 520 are threadedly matched with the threaded rods 510 in one-to-one correspondence for fixedly connecting the cooling structure 400, the support plate 120, and the washers 530.

According to the structural form of the aforementioned first distance adjusting piece 500, the range of the vertical distance between the cooling structure 400 and the heater 300 can be achieved by changing the number and/or thickness of the washers 530 for ease of adjustment. Moreover, fixing of the cooling structure 400 on the support plate 120 is also achieved by means of the locking action of the nuts 520, preventing displacement and misalignment of the cooling structure 400 during operation of the wafer carrying mechanism, and further ensuring cooling reliability of the cooling structure 400 for the carrying plate 200. Of course, the first distance adjusting piece 500 of any other structure may be used to adjust the vertical distance between the support plate 120 and the cooling structure 400 in practical applications, and the present application is not particularly limited thereto.

Furthermore, there are a plurality of threaded rods 510, and the threaded rods 510 are arranged at intervals along the circumference of the support plate 120, by such arrangement, on the one hand, stability of the raising or lowering of the cooling structure 400 at various positions along the circumference can be guaranteed, avoiding deflection due to uneven local force on the cooling structure 400, and on the other hand, reliability of the connection of the cooling structure 400 and the support plate 120 can be guaranteed. The number of the threaded rods 510 is for example 5, and correspondingly, as shown in FIG. 5, the number of the first unthreaded holes 121 is 5. It will be appreciated that in other embodiments, the threaded rods 510 can also be provided in other numbers, such as four, six, or eight, etc.; the number of the nuts 520 and the number of the first unthreaded holes 121 are both the same as the number of the threaded rods 510.

It is to be noted that in the present embodiment, the washer 530 is disposed on the threaded rod 510 in a sleeving mode. By such arrangement, it is able to limit the washer 530 using the threaded rod 510, thereby ensuring stable support of the washer 530 to the cooling structure 400. However, the disclosure is not limited thereto, and in practical applications, the washer 530 can be disposed anywhere between the cooling structure 400 and the support plate 120 instead of being disposed on the threaded rod 510 in a sleeving mode.

With continued reference to FIG. 4, in some optional embodiments, the threaded rod 510 is integrated with the cooling structure 400, specifically, the two are joined together by welding.

With continued reference to FIGS. 1 and 5, in some optional embodiments, the flange plate 110 has a central through hole 110a, and a first connecting portion 111 is provided on a hole wall of the central through hole 110a; a portion of the support plate 120 is located in the central through hole 110a, and a second connecting portion 124 is provided on an outer peripheral wall of the support plate 120; the second connecting portion 124 and the first connecting portion 111 are disposed in a superimposing mode, and the second connecting portion 124 is located under the first connecting portion 111; a plurality of threaded holes are provided on the first connecting portion 111 at intervals along the circumference of the support plate 120, and a plurality of second unthreaded holes 122 are provided on the second connecting portion 124; the number of the second unthreaded holes 122 is the same as the number of the threaded holes and the second unthreaded holes 122 and the threaded holes are provided in one-to-one correspondence; moreover, the second distance adjusting piece 600 includes screws; the number of the screws is the same as the number of the aforementioned threaded holes; and the screws pass through the second unthreaded holes 122 in one-to-one correspondence and are threadedly connected to the corresponding threaded holes.

When the vertical distance between the cooling structure 400 and the heater 300 needs to be adjusted using the second distance adjusting piece 600, specifically, as shown in FIG. 1, when it is required to increase the vertical distance between the cooling structure 400 and the heater 300, the screw can be rotated to move the screw in a direction out of the threaded hole (i.e., downwards), at which point the support plate 120 moves downwards and always abuts against the head of the screw, thereby increasing the vertical distance between the cooling structure 400 and the heater 300; when it is required to reduce the vertical distance between the cooling structure 400 and the heater 300, the screw can be rotated to move the screw in a direction, opposite to the aforementioned rotating direction, of entering the screw hole, at which point the support plate 120 will move upwards under the support of the head of the screw to bring the cooling structure 400 near the heater 300, thereby reducing the vertical distance between the cooling structure 400 and the heater 300.

The second distance adjusting piece 600 is provided in a form that is simple in structure and easy to implement.

In some optional embodiments, there are a plurality of screws in the second distance adjusting piece 600, and the screws are arranged at intervals along the circumference of the support plate 120. By such arrangement, the support plate 120 can be smoothly raised or lowered at various positions along the circumference, avoiding deflection of the cooling structure 400 due to the uneven local force on the support plate 120. For example, the number of the screws is 6, and correspondingly, as shown in FIG. 5, the number of second unthreaded holes 122 is 6. It will be appreciated that in other embodiments, the screws can also be provided in other numbers, such as four, six or eight, etc.; the number of the threaded holes and the number of the second unthreaded holes 122 are both the same as the number of the threaded rods 510.

Preferably, in the present embodiment, the vertical distance between the cooling structure 400 and the heater 300 is greater than or equal to 0.5 mm and less than or equal to 4 mm, that is, the distance adjusting assembly adjusts the distance between the cooling structure 400 and the heater 300 in the range of 0.5 mm to 4 mm. By such arrangement, the requirements of different high-temperature processes can be met, and the overall thickness of the wafer carrying mechanism can also be reduced, thereby facilitating a compact design of the wafer carrying mechanism of the present embodiment.

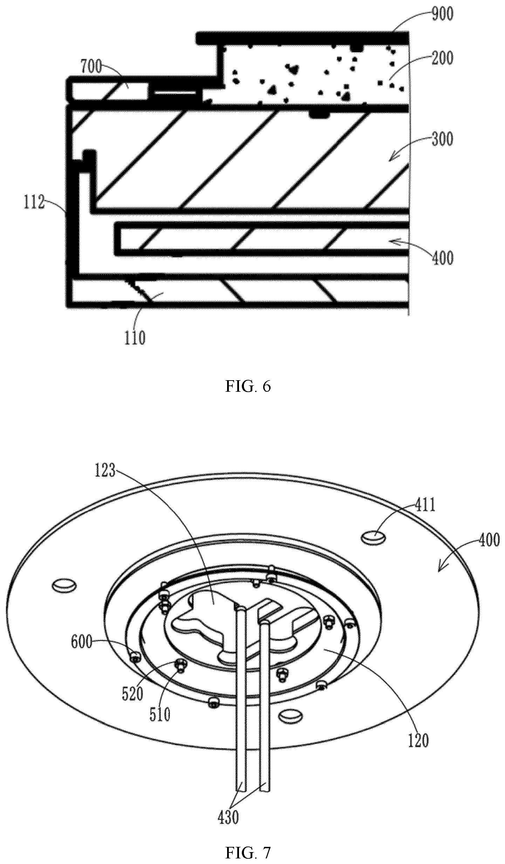

FIG. 6 is an enlarged view of a partial structure of the structure shown in FIG. 1. With continued reference to FIG. 1, in conjunction with FIG. 6, in some optional embodiments, a connecting wall 112 extending in the direction of the heater 300 is provided on the flange plate 110 and at an edge of the flange plate 110, and the connecting wall 112 is fixedly connected, for example by welding, to the heater 300. The aforementioned accommodating space is formed between an inner peripheral surface of the connecting wall 112, a lower surface of the heater 300 and an upper surface of the flange plate 110. For example, the connecting wall 112 is welded with the heater body 310 of the heater 300, that is, a side wall of the accommodating space is formed by the connecting wall 112.

In a high-temperature state, a temperature difference is generated between the heater body 310 and the flange plate 110, and an internal stress is generated by the difference in the amount of expansion ; and by providing the connecting wall 112 extending in the direction of the heater 300 at the outer periphery of the flange plate 110 and fixedly connecting the connecting wall 112 to the heater body 310, the connecting wall 112 is relatively thin, which can deform in a high-temperature state to relieve the internal stress caused by the temperature difference. Moreover, reliable connection between the flange plate 110 and the heater body 310 derives from the manner that the connecting wall 112 is fixedly connected to the heater body 310.

Specifically, in some optional embodiments, the thickness of the connecting wall 112 is 1 mm or less.

With continued reference to FIG. 4, in some optional embodiments, the cooling structure 400 includes a cooling screen 410, and a cooling plate 420 connected to a bottom of the cooling screen 410, specifically, the cooling plate 420 is provided with a flow channel, the flow channel is used for delivering a cooling liquid, and a radial dimension of the cooling screen 410 is greater than or equal to a radial dimension of the carrying plate 200.

In the wafer carrying mechanism, the range within the maximum outer diameter of the cooling screen 410 is an optimal cooling range, and the cooling screen 410 has high cooling efficiency within its maximum outer diameter and low cooling efficiency beyond the maximum outer diameter; by setting the radial dimension of the cooling screen 410 greater than or equal to the radial dimension of the carrying plate 200, the cooling structure 400 is able to achieve overall cooling of the carrying plate 200, which not only has high cooling efficiency but also has good cooling uniformity.

Specifically, the wafer carrying mechanism has a radiant heat flow rate Q, and the heat flow rate Q is calculated by the formula: $Q = 5.67 \times 10^{-8} \varepsilon A (T1^4 - T2^4)$, where the energy flux density radiated from the surface of an absolute blackbody at a temperature of 100K is 5.67 $W/m^2$, $\varepsilon$ is the average emissivity, A is the radiant area, T1 is the temperature of the heater 300, and T2 is the temperature of the cooling structure 400. As can be seen, the greater the radiant area A, the greater the heat flow rate Q, and the greater the radiant heat transfer efficiency, and thus, increasing the cooling area of the cooling screen 410 may effectively increase the radiant heat transfer amount to achieve efficient cooling of the carrying plate 200.

FIG. 7 is a partial structural view of the wafer carrying mechanism according to an embodiment. With continued reference to FIG. 4, in conjunction with FIG. 7, in some optional embodiments, the cooling structure 400 may further include cooling liquid tubes 430, and the cooling liquid tubes 430 are in communication with the flow channel provided in the cooling plate 420 for inputting a cooling liquid into the flow channel.

With continued reference to FIG. 7, in some optional embodiments, process holes 411 may also be provided on the cooling structure 400 to meet corresponding process needs. In addition, a middle portion of the support plate 120 may also be provided with a routing hole 123, and the routing hole 123 enables passing of the cooling liquid tubes 430 and other cables of the wafer carrying mechanism, ensuring structural compactness and neat appearance of the wafer carrying mechanism.

In addition, the present embodiments also provide a semiconductor process apparatus, the semiconductor process apparatus includes a process chamber and the aforementioned wafer carrying mechanism, specifically, the wafer carrying mechanism is disposed within the process chamber.

By providing the aforementioned wafer carrying mechanism within the process chamber of the semiconductor process apparatus, the semiconductor process apparatus accordingly has all the advantages of the aforementioned wafer carrying mechanism, which are not described in any further detail herein.

Although the present application is disclosed above, the present application is not limited thereto.

Various changes and modifications may be made by anyone skilled in the art without departing from the scope of the present application, and the scope of the present application shall accordingly be defined by the claims.

Finally, it should also be noted that relational terms such as first and second and the like are used herein solely to distinguish one entity or operation from another entity or operation without necessarily requiring or implying any actual relationship or order between such entities or operations. Furthermore, the terms "includes" or any other variation thereof, are intended to cover a non-exclusive inclusion, such that a process, method, article, or apparatus that includes a list of elements not only includes those elements but also includes other elements not expressly listed or inherent to such process, method, article, or apparatus. In the absence of further limitations, an element defined by the phrase "includes an ..." does not preclude the existence of another identical element in the process, method, article or apparatus including the element.

Descriptions of orientations such as "upper", "lower", and the like in the aforementioned embodiments are based on what is shown in the drawings.

The aforementioned description of the disclosed embodiments enables any person skilled in the art to make or use the present application. The invention is defined by the appended claims.

## Claims

1.  A wafer carrying mechanism, used for a semiconductor process apparatus, the wafer carrying mechanism being disposed in a process chamber of the semiconductor process apparatus, the wafer carrying mechanism comprising a mounting support (100), a carrying plate (200), a heater (300), and a cooling structure (400), wherein the mounting support (100) is fixedly disposed in the process chamber, the heater (300) is disposed on the mounting support (100), and an accommodating space is formed between the heater (300) and the mounting support (100); the cooling structure (400) is located in the accommodating space and is mounted to the mounting support (100) through a distance adjusting assembly, the distance adjusting assembly being used for adjusting a distance between the cooling structure (400) and the heater (300); and the carrying plate (200) is disposed on the heater (300) and is attached to the heater (300); **characterized in that** the mounting support (100) comprises a flange plate (110) and a support plate (120), the flange plate (110) is connected to the heater (300) and has a central through hole, and the support plate (120) is disposed at the central through hole and connected to the flange plate (110), and at least a portion of the support plate is located in the accommodating space and connected to the cooling structure for supporting the cooling structure; and the distance adjusting assembly comprises a first distance adjusting piece (500) and/or a second distance adjusting piece (600), the cooling structure (400) is mounted to the support plate (120) by the first distance adjusting piece (500), and/or, the support plate (120) is connected to the flange plate (110) by the second distance adjusting piece (600).

2.  The wafer carrying mechanism according to claim 1, wherein the distance adjusting assembly comprises the first distance adjusting piece (500) and the first distance adjusting piece (500) comprises a threaded rod (510), a nut (520), and one or more washers (530), the threaded rod (510) is connected to the cooling structure (400), a first unthreaded hole (121) is provided at a position corresponding to the threaded rod (510) on the support plate (120), the threaded rod (510) penetrates through the first unthreaded hole (121) and is locked by nut (520), and the one or more washers (530) are disposed between the cooling structure (400) and the support plate (120) for adjusting a distance between the cooling structure (400) and the support plate (120).

3.  The wafer carrying mechanism according to claim 1, wherein the distance adjusting assembly comprises the second distance adjusting piece (600) and the second distance adjusting piece (600) comprises a screw, an inner wall of the flange plate (110) extends in a direction toward the central through hole to form a connection portion (111), a screw hole is provided at the connection portion (111), a second unthreaded hole (122) is provided at a position corresponding to the screw hole on the support plate (120), and the screw passes through the second unthreaded hole (122) to be fixed in the screw hole.

4.  The wafer carrying mechanism according to claim 1, wherein a connecting wall (112) extending in a direction toward the heater (300) is provided at an outer periphery of the flange plate (110), and the connecting wall (112) is connected to the heater (300) by welding.

5.  The wafer carrying mechanism according to any one of claims 1-4, wherein the wafer carrying mechanism further comprises a pressing ring (700), the carrying plate (200) is disposed on the heater (300) by the pressing ring (700), the pressing ring (700) comprises an annular body (710) surrounding the carrying plate (200), and pressing teeth (720) disposed in the annular body (710), the annular body (710) is connected to the heater (300), and the pressing teeth (720) are elastically superimposed on the carrying plate (200) for pressing the carrying plate (200) against the heater (300).

6.  The wafer carrying mechanism according to any one of claims 1-4, wherein the distance between the cooling structure (400) and the heater (300) is between 0.5 mm and 4 mm.

7.  The wafer carrying mechanism according to any one of claims 1-4, wherein the heater (300) comprises a heater body (310), and a heating wire (320) embedded in the heater body (310).

8.  The wafer carrying mechanism according to any one of claims 1-4, wherein the cooling structure (400) comprises a cooling screen (410) and a cooling plate (420), which are connected to each other, the cooling plate (420) is provided with a flow channel, the flow channel is used for flowing of a cooling liquid, and a radial dimension of the cooling screen (410) is greater than or equal to a radial dimension of the carrying plate (200).

9.  A semiconductor process apparatus, comprising a process chamber and the wafer carrying mechanism according to any one of claims 1-8, the wafer carrying mechanism being disposed within the process chamber.

**Patentansprüche**

1.  Waferträgermechanismus, der für eine Halbleiterprozessvorrichtung verwendet wird, wobei der Waferträgermechanismus in einer Prozesskammer der Halbleiterprozessvorrichtung angeordnet ist, wobei der Waferträgermechanismus einen Befestigungshalter (100), eine Trägerplatte (200), eine Heizvorrichtung (300) und eine Kühlstruktur (400) aufweist, wobei der Befestigungshalter (100) fest in der Prozesskammer angeordnet ist, die Heizvorrichtung (300) auf dem Befestigungshalter (100) angeordnet ist und zwischen der Heizvorrichtung (300) und dem Befestigungshalter (100) ein Aufnahmeraum gebildet ist; die Kühlstruktur (400) sich in dem Aufnahmeraum befindet und über eine Abstandseinstellvorrichtung an dem Befestigungshalter (100) befestigt ist, wobei die Abstandseinstellvorrichtung zum Einstellen eines Abstands zwischen der Kühlstruktur (400) und der Heizvorrichtung (300) verwendet wird; und die Trägerplatte (200) auf der Heizvorrichtung (300) angeordnet und an der Heizvorrichtung (300) angebracht ist;
    **dadurch gekennzeichnet, dass**
    der Befestigungshalter (100) eine Flanschplatte (110) und eine Halterplatte (120) aufweist, wobei die Flanschplatte (110) mit der Heizvorrichtung (300) verbunden ist und ein zentrales Durchgangsloch hat und die Halterplatte (120) an dem zentralen Durchgangsloch angeordnet und mit der Flanschplatte (110) verbunden ist und mindestens ein Abschnitt der Halterplatte sich in dem Aufnahmeraum befindet und mit der Kühlstruktur verbunden ist, um die Kühlstruktur zu halten; und die Abstandseinstellvorrichtung ein erstes Abstandseinstellstück (500) und/oder ein zweites Abstandseinstellstück (600) aufweist, wobei die Kühlstruktur (400) durch das erste Abstandseinstellstück (500) an der Halterplatte (120) befestigt ist und/oder die Halterplatte (120) über das zweite Abstandseinstellstück (600) mit der Flanschplatte (110) verbunden ist.

2. Waferträgermechanismus nach Anspruch 1, wobei die Abstandseinstellvorrichtung das erste Abstandseinstellstück (500) aufweist und das erste Abstandseinstellstück (500) eine Gewindestange (510), eine Mutter (520) und eine oder mehrere Unterlegscheiben (530) aufweist, wobei die Gewindestange (510) mit der Kühlstruktur (400) verbunden ist, ein erstes nicht mit Gewinde versehenes Loch (121) an einer Position, die der Gewindestange (510) auf der Halterplatte (120) entspricht, vorgesehen ist, die Gewindestange (510) durch das erste nicht mit Gewinde versehene Loch (121) hindurchragt und durch die Mutter (520) arretiert ist und die eine oder mehreren Unterlegscheiben (530) zwischen der Kühlstruktur (400) und der Halterplatte (120) zum Einstellen eines Abstands zwischen der Kühlstruktur (400) und der Halterplatte (120) angeordnet sind.

3. Waferträgermechanismus nach Anspruch 1, wobei die Abstandseinstellvorrichtung das zweite Abstandseinstellstück (600) aufweist und das zweite Abstandseinstellstück (600) eine Schraube aufweist, wobei sich eine Innenwand der Flanschplatte (110) in Richtung des zentralen Durchgangslochs erstreckt, um einen Verbindungsabschnitt (111) zu bilden, ein Schraubenloch an dem Verbindungsabschnitt (111) vorgesehen ist, ein zweites nicht mit Gewinde versehenes Loch (122) an einer Position, die dem Schraubenloch auf der Halterplatte (120) entspricht, vorgesehen ist und die Schraube durch das zweite nicht mit Gewinde versehene Loch (122) hindurchgeht, um in dem Schraubenloch befestigt zu werden.

4. Waferträgermechanismus nach Anspruch 1, wobei eine Verbindungswand (112), die sich in Richtung der Heizvorrichtung (300) erstreckt, an einem Außenumfang der Flanschplatte (110) vorgesehen ist und die Verbindungswand (112) durch Schweißen mit der Heizvorrichtung (300) verbunden ist.

5. Waferträgermechanismus nach einem der Ansprüche 1 bis 4, wobei der Waferträgermechanismus ferner einen Druckring (700) aufweist, die Trägerplatte (200) durch den Druckring (700) auf der Heizvorrichtung (300) angeordnet ist, der Druckring (700) einen ringförmigen Körper (710), der die Trägerplatte (200) umgibt, und Druckzähne (720) aufweist, die in dem ringförmigen Körper (710) angeordnet sind, der ringförmige Körper (710) mit der Heizvorrichtung (300) verbunden ist und die Druckzähne (720) elastisch auf die Trägerplatte (200) aufgesetzt sind, um die Trägerplatte (200) gegen die Heizvorrichtung (300) zu drücken.

6. Waferträgermechanismus nach einem der Ansprüche 1 bis 4, wobei der Abstand zwischen der Kühlstruktur (400) und der Heizvorrichtung (300) zwischen 0,5 mm und 4 mm beträgt.

7. Waferträgermechanismus nach einem der Ansprüche 1 bis 4, wobei die Heizvorrichtung (300) einen Heizkörper (310) und einen Heizdraht (320), der in den Heizkörper (310) eingebettet ist, aufweist.

8. Waferträgermechanismus nach einem der Ansprüche 1 bis 4, wobei die Kühlstruktur (400) einen Kühlschirm (410) und eine Kühlplatte (420) aufweist, die miteinander verbunden sind, wobei die Kühlplatte (420) mit einem Strömungskanal versehen ist, wobei der Strömungskanal dazu dient, eine Kühlflüssigkeit zu leiten, und eine radiale Abmessung des Kühlschirms (410) größer oder gleich einer radialen Abmessung der Trägerplatte (200) ist.

9. Halbleiterprozessvorrichtung, eine Prozesskammer und den Waferträgermechanismus nach einem der Ansprüche 1 bis 8 aufweisend, wobei der Waferträgermechanismus im Inneren der Prozesskammer angeordnet ist.

## Revendications

1. Mécanisme de support d'une galette de silicium, utilisé pour un appareil de traitement de semi-conducteurs, le mécanisme de transport de galette comprend un support de montage (100), une plaque de support (200), un chauffage (300) et une structure de refroidissement (400), où le support de montage (100) est disposé de manière fixe dans la chambre de traitement, le chauffage (300) est disposé sur le support de montage (100) et un espace d'accueil est formé entre le dispositif de chauffage (300) et le support de montage (100) ; la structure de refroidissement (400) est située dans l'espace d'accueil et est montée sur le support de montage (100) par l'intermédiaire d'un ensemble de réglage de la distance, l'ensemble de réglage de la distance étant utilisé pour régler une distance entre la structure de refroidissement (400) et le dispositif de chauffage (300) ; et la plaque de support (200) est disposée sur l'élément chauffant (300) et est fixée à l'élément chauffant (300) ;
**caractérisé en ce que**

le support de montage (100) comprend une plaque à bride (110) et une plaque de support (120), la plaque à bride (110) est reliée au dispositif de chauffage (300) et possède un trou traversant central, et la plaque de support (120) est disposée au niveau du trou central et reliée au dispositif de chauffage (300) et et reliée à la plaque à bride (110), et au moins une partie de la plaque de support est située dans l'espace d'accueil et reliée à la structure de refroidissement dans l'espace d'accueil et reliée à la structure de refroidissement pour soutenir la structure de refroidissement ; et l'ensemble de réglage de la distance comprend une première pièce de réglage de la distance (500) et/ou une deuxième pièce de réglage de la distance (600), la structure de refroidissement (400) étant montée sur la plaque de support (120) par la première pièce de réglage de la distance (500), et/ou la plaque de support (120) étant reliée à la plaque à bride (110) par la deuxième pièce de réglage de la distance (600).

2. Mécanisme de support de galette selon la revendication 1, dans lequel l'ensemble de réglage de la distance comprend la première pièce de réglage de la distance (500) et la première pièce de réglage de la distance (500) comprend une tige filetée (510), un écrou (520) et une ou plusieurs rondelles (530), la tige filetée (510) est reliée à la structure de refroidissement (400), un premier trou non fileté (121) est prévu à une position correspondant à la tige filetée (510) sur la plaque de support (120), la tige filetée (510) pénètre à travers le premier trou non fileté (121) et est bloquée par l'écrou (520), et une ou plusieurs rondelles (530) sont disposées entre la structure de refroidissement (400) et la plaque de support (120) pour ajuster une distance entre la structure de refroidissement (400) et la plaque de support (120).

3. Mécanisme de support de galette selon la revendication 1, dans lequel l'ensemble de réglage de la distance comprend la deuxième pièce de réglage de la distance (600) et la deuxième la pièce de réglage de la distance (600) comprend une vis, une paroi intérieure de la plaque à bride (110) s'étend en direction du trou central pour former une partie de connexion (111), un trou de vis est prévu dans la partie de connexion (111), un deuxième trou non fileté (122) est prévu à une position correspondant au trou de vis sur la plaque de support (120), et la vis passe à travers le deuxième trou non fileté (122) pour être fixée dans le trou de vis.

4. Mécanisme de support de galette selon la revendication 1, dans lequel une paroi de connexion (112) s'étendant dans une direction vers le dispositif de chauffage (300) est fournie à une périphérie extérieure de la plaque à bride (110), et la paroi de connexion (112) est connectée au dispositif de chauffage (300) par soudage.

5. Mécanisme de support de galette selon l'une des revendications 1 à 4, dans lequel le mécanisme de support de galette comprend en outre un anneau de pression (700), la plaque de transport (200) est disposée sur le dispositif de chauffage (300) par l'anneau de pression (700), l'anneau de pression (700) comprend un corps annulaire (710) entourant la plaque de support (200), et des dents de pression (720) disposées dans le corps annulaire (710), le corps annulaire (710) est relié au dispositif de chauffage (300), et les dents de pression (720) sont superposées élastiquement sur la plaque de transport (200), et les dents de pression (720) sont superposées élastiquement sur la plaque de support (200) pour presser la plaque de support (200) contre l'élément chauffant (300).

6. Mécanisme de support de galette selon l'une des revendications 1 à 4, dans lequel la distance entre la structure de refroidissement (400) et le dispositif de chauffage (300) est comprise entre 0,5 mm et 4 mm.

7. Mécanisme de support de galette selon l'une des revendications 1 à 4, dans lequel l'élément chauffant (300) comprend un corps de chauffe (310) et un fil chauffant (320) encastré dans le corps de chauffe (310).

8. Mécanisme de support de galette selon l'une des revendications 1 à 4, dans lequel la structure de refroidissement (400) comprend un écran de refroidissement (410) et une plaque de refroidissement (420), qui sont reliés l'un à l'autre, la plaque de refroidissement (420) étant pourvue d'un canal d'écoulement utilisé pour l'écoulement d'un liquide de refroidissement, et une dimension radiale de l'écran de refroidissement (410) est supérieure ou égale à une dimension radiale de la plaque de support (200).

9. Appareil de traitement de semi-conducteurs, comprenant une chambre de traitement et un mécanisme de support de galette selon l'une des revendications 1 à 8, le mécanisme de support de galette étant placé dans la chambre de traitement.

FIG. 1

FIG. 2

FIG. 3

FIG. 4

FIG. 5

FIG. 6

FIG. 7

**EP 4 234 757 B1**

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- CN 111477569 A
- WO 2020073779 A1